# EUROPÄISCHE PATENTSCHRIFT

(11) **EP 0 401 211 B1**
(45) Veröffentlichungstag und Bekanntmachung des Hinweises auf die Patenterteilung: **19.05.1993**
(21) Anmeldenummer: 88902121.8
(22) Anmeldetag: 20.02.1988
(51) Int. Cl.: H01L 23/24, H01L 21/56, H01L 21/52

(54) **HALBLEITERBAUELEMENT, HERSTELLUNGSVERFAHREN, VORRICHTUNG UND MONTAGEPLATZ**
SEMICONDUCTOR COMPONENT, MANUFACTURING PROCESS, DEVICE AND ASSEMBLY STATION
ELEMENT SEMI-CONDUCTEUR, PROCEDE DE FABRICATION, DISPOSITIF ET STATION DE MONTAGE

(43) Veröffentlichungstag der Anmeldung: 12.12.1990
(73) Patentinhaber: Deutsche ITT Industries GmbH, 79108 Freiburg (DE)
(72) Erfinder: HEITZLER, Viktor, D-7801 Umkirch (DE); KAPP, Richard, D-7804 Glottertal (DE)
(86) Internationale Anmeldenummer: EP8800125
(87) Internationale Veröffentlichungsnummer: WO8907835

(56) Entgegenhaltungen:
- EP-A- 0 009 135
- EP-A- 0 066 188
- EP-A- 0 100 574
- FR-A- 2 360 174
- FR-A- 2 390 008
- Patent Abstracts of Japan, Band 7, No. 233 (E-204)(1378), 15 Oktober 1983, & JP, A, 58121652
- Patent Abstracts of Japan, Band 9, Nr. 298 (E-361)(2021), 26 November 1985, & JP, A, 60136347
- Patent Abstracts of Japan, Band 9, Nr. 318 (E-366)(2041), 13 Dezember 1985, & JP, A, 60150654

## Beschreibung

Eine der heute am weitesten verbreiteten Kunststoffumhüllungen für Kleinleistungs-Halbleiterbauelemente, wie z.B. Transistoren, Thyristoren oder ähnliche Halbleiterbauelemente mit drei Zuleitungen, ist das genormte TO-92-Gehäuse, dessen räumliche Form einem Kreiszylinder mit parallel zur Mittellinie abgeschnittenem Sektor entspricht. Der Halbleiterkörper und dessen Zuleitungen sind in den Kunststoff hermetisch eingebettet und somit gegen mechanische Beanspruchung und chemische Einflüsse, z.B. das Eindringen von Feuchtigkeit, geschützt.

Bei der Herstellung derartiger Halbleiterbauelemente mit Kunststoffumhüllung ist einerseits der Ausgangspunkt für den Halbleiterkörper eine Halbleiterplatte, an der mehrere hundert bis mehrere tausend identische Halbleiterkörper hergestellt werden, und andererseits der Ausgangspunkt für die Zuleitungen des Halbleiterbauelements ein Montageband (lead frame), an dem ebenfalls mehrere tausend Zuleitungen mechanisch fest durch Querstege miteinander verbunden sind, die in einem der letzten Herstellungsschritte der Halbleiterbauelemente vor der Endmessung entfernt werden, um den durch die Querstege gebildeten Kurzschluß der Zuleitungen zu beseitigen.

Von dem zu einem einzelnen Halbleiterbauelement gehörenden Satz von Zuleitungen, beim genannten TO-92-Gehäuse ist es ein Zuleitungstripel, hat das innere Ende der einen Zuleitung eine so große Fläche, daß darauf der Halbleiterkörper elektrisch leitend, z.B. mittels eines Leitklebers, befestigt werden kann.

Bei der Herstellung läuft das unbestückte Montageband von einer Rolle ab und gelangt zunächst zu einer Halbleiterkörper-Aufbringstation, in der die einzelnen Halbleiterkörper von der Halbleiterscheibe abgenommen und auf der dafür vorgesehenen Fläche der Zuleitung befestigt werden. Danach werden in einer Bondstation die inneren Enden der weiteren Zuleitungen des Halbleiterbauelements durch feine Drähte mit entsprechenden Zonen des Halbleiterkörpers verbunden. Anschließend werden der Halbleiterkörper und die feinen Drähte mit einer Kunstharzabdeckung versehen, worauf das Montageband wieder zu einer Rolle aufgewickelt wird, da das Umpressen oder Umspritzen mit der Kunststoffumhüllung räumlich getrennt von den bisher beschriebenen Herstellschritten erfolgt. Daraus folgt auch eine sehr lange Gesamtdurchlaufzeit einer Montagebandrolle durch sämtliche Herstellungsstufen.

Das Aufbringen des Halbleiterkörpers auf das Montageband, dessen Kontaktierung mit den Zonen des Halbleiterkörpers und dessen Abdeckung ist von der Anbringung der Kunststoffumhüllung aus mehreren Gründen räumlich getrennt. Zum einen sind die entsprechenden Vorrichtungen sehr unterschiedlich groß und können somit nicht räumlich direkt einander zugeordnet werden. Zum anderen handelt es sich bei den Umhüllungsvorrichtungen z.B. um Pressen, die mit großem Druck arbeiten und somit schwerere Fundamente erfordern als die Aufsockel-, Bond- und Abdeckvorrichtungen. Schließlich arbeiten die letztgenannten Vorrichtungen und die Pressen mit unterschiedlichen Zeittakten, die nur schwer aneinander angepaßt werden können.

Auch entstehen bei der geschilderten Herstellungsweise zwischen den einzelnen Zuleitungen sogenannte Schwimmhäute, die sich nicht vermeiden lassen, da einer der erwähnten Querstege zur Abdichtung der Spritz- oder Preßform erforderlich ist. Diese Schwimmhäute müssen in einem getrennten Arbeitsgang durch einen sandstrahlartigen Verfahrensschritt entfernt werden, zu dessen Arbeitsplatz die nach dem Kunststoffumhüllen wiederum zu einer Rolle aufgewickelten Montagebänder gebracht werden müssen.

Schließlich bedingt das geschilderte Herstellungsverfahren die Benutzung einer den speziellen Anforderungen sowohl an das Umspritzen bzw. Umpressen als auch an die eingangs genannten Eigenschaften angepaßten Kunststoffzusammensetzung, d.h. die Auswahl der Kunststoffe unterliegt einer ganzen Reihe von einschränkenden Randbedingungen. Sie müssen z.B. ausreichend bei möglichst geringem Druck fließfähig sein, um die Preßform vollständig und ohne Lunkerbildung auszufüllen, und trotzdem ihre Schutzfunktion am fertigen Halbleiterbauelement erfüllen.

Obwohl das geschilderte Herstellungsverfahren ein bewährtes Massenverfahren ist und sich als bisher kostengünstigstes derart stark durchgesetzt hat, daß es als heutiges Standardverfahren bezeichnet werden kann, besteht das Bestreben, davon, insbesondere unter dem Gesichtspunkt einer weiteren Reduzierung der Herstellungskosten der Halbleiterbauelemente, abzugehen und Halbleiterbauelemente zu schaffen, die noch kostengünstiger hergestellt werden können.

Aus Patent Abstracts of Japan, Band 7, Nr. 233 (E-204)[1378], 15. Oktober 1983 & JP-A-58121652 ist ein Halbleiterbauelement bekannt, bei dem das mit Zuleitungen versehene Halbleiterbauteil auf dem Boden eines becherförmigen Gehäuses fixiert und das Gehäuse mit einem Gießharz gefüllt wird, wobei die Seitenwände des Gehäuses eine parallel zum Boden verlaufende Nut halten. Das Gießharz dringt in die Nut ein, wobei die Festigkeit des Gießharzes im Becher verbessert wird.

Die Aufgabe der in den Ansprüchen gekennzeichneten Erfindung in ihren verschiedenen Patentkategorien besteht somit darin, ein Halbleiterbauelement anzugeben, das zwar eine Kunststoffumhüllung hat, die jedoch im Hinblick auf die Kostenreduzierung anders als die bisher weitverbreiteten Kunststoffumhüllungen aufgebaut ist. Dabei sollen auch die Zuleitungen von der bisherigen Art soweit abweichend ausgebildet sein, wie es die neuartige Kunststoffumhüllung erforderlich macht. Ferner liegt es im Rahmen der Aufgabe der Erfindung, eine Vorrichtung anzugeben, mit der das Aufbringen der Kunststoffumhüllung auf das mit den Halbleiterkörpern etc. versehene Montageband möglich ist. Schließlich soll auch eine Montagestation angegeben werden, in die das unbestückte Montageband einläuft und von der das mit den kunststoffumhüllten Halbleiterbauelementen bestückte Montageband abgenommen werden kann.

Einer der Grundgedanken der Erfindung besteht darin, das bei der bisherigen Herstellungsart erst während des Umspritzens oder Umpressens des Halbleiterkörpers etc. am Montageband entstehende Kunststoffgehäuse für sich in einem eigenen Herstellvorgang als becherförmiges Gehäuse herzustellen, womit z.B. der Vorteil einer größeren Freiheit in der Wahl des zu verwendenden Ausgangskunststoffs sowie der beim Umpressen oder Umspritzen anzuwendenden Temperaturen und Drücke verbunden ist, ferner den Becher mit einem Gießharz vor dem Einbringen des Halbleiterkörpers etc. zu füllen und schließlich die Becheraufbringstation räumlich eng mit den Stationen für das Aufbringen des Halbleiterkörpers etc. zu vereinigen.

Als Vorteile der Erfindung sind zu nennen: Es kann ein billiger Kunststoff für die Becher benutzt werden. Der Verfahrensschritt des Entfernens der Schwimmhäute entfällt und somit auch die entsprechende Vorrichtung. Die Pressen zur Herstellung der becherförmigen Gehäuse können einfacher aufgebaut und somit kleiner als die bisherigen Pressen sein. Es entfallen zwei Transportwege für die bestückten Montagerollen (Montageplatz bisheriger Art - Pressen, Pressen - Sandstrahlvorrichtung). Dadurch läßt sich die erwähnte Gesamtdurchlaufzeit der Montagebandrollen erheblich, z. B. um mehr als die Hälfte, reduzieren. Alle zur Herstellung der Kunststoffumhüllung mit dem Halbleiterkörper und seinen Zuleitungen erforderlichen Verfahrensschritte können an einem einzigen Montageplatz vorgenommen werden, der nicht mehr Fläche einnimmt als ein bisheriger Montageplatz, so daß wie bisher eine große Anzahl solcher Montageplätze in einer Fertigungshalle untergebracht werden kann, da die Becheraufbringstation oberhalb von den Stationen des bisherigen Montageplatzes angeordnet werden können.

Die Erfindung wird nun anhand der Figuren der Zeichnung näher erläutert.
Fig. 1 zeigt perspektivisch ein Ausführungsbeispiel des erfindungsgemäßen Halbleiterbauelements,
Fig. 2 zeigt vergrößert die Vorderansicht des Ausführungsbeispiels der Fig. 1 ohne Gießharzfüllung,
Fig. 3 zeigt den zentralen Vertikalschnitt der Anordnung der Fig. 1,
Fig. 4 zeigt ein Ausführungsbeispiel eines bei der Erfindung verwendeten Montagebandes,
Fig. 5 zeigt perspektivisch und schematisiert ein Ausführungsbeispiel einer erfindungsgemäßen Vorrichtung zum Einbringen von Halbleiterkörpern und ihren Zuleitungen in becherförmige Gehäuse,
Fig. 6 zeigt das Schema des Ausführungsbeispiels eines Montageplatzes nach der Erfindung, und
Fig. 7 zeigt schematisch Ausführungsbeispiele eines Teils der Stationen des Montageplatzes nach Fig. 6.

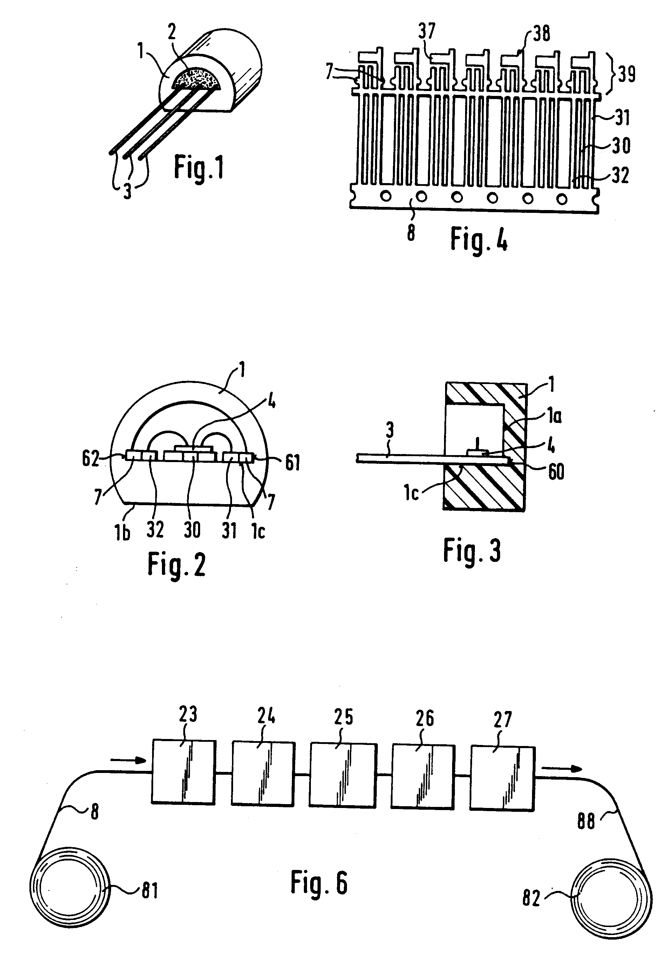

Das Ausführungsbeispiel der Fig. 1 zeigt perspektivisch einen Transistor oder Thyristor im oben bereits erwähnten TO-92-Gehäuse. Das becherförmige Gehäuse 1, im folgenden kurz Becher genannt, ist mit dem Gießharz 2 gefüllt, das am fertigen Bauelement ausgehärtet ist. Das Gießharz ist bei Raumtemperatur zum Einfüllen in die Becher 1 ausreichend flüssig. Aus dem Gießharz 2 ragen die drei Zuleitungen 3 hervor, über die der Transistor oder der Thyristor mit der Schaltung, in der er verwendet werden soll, verbunden werden kann.

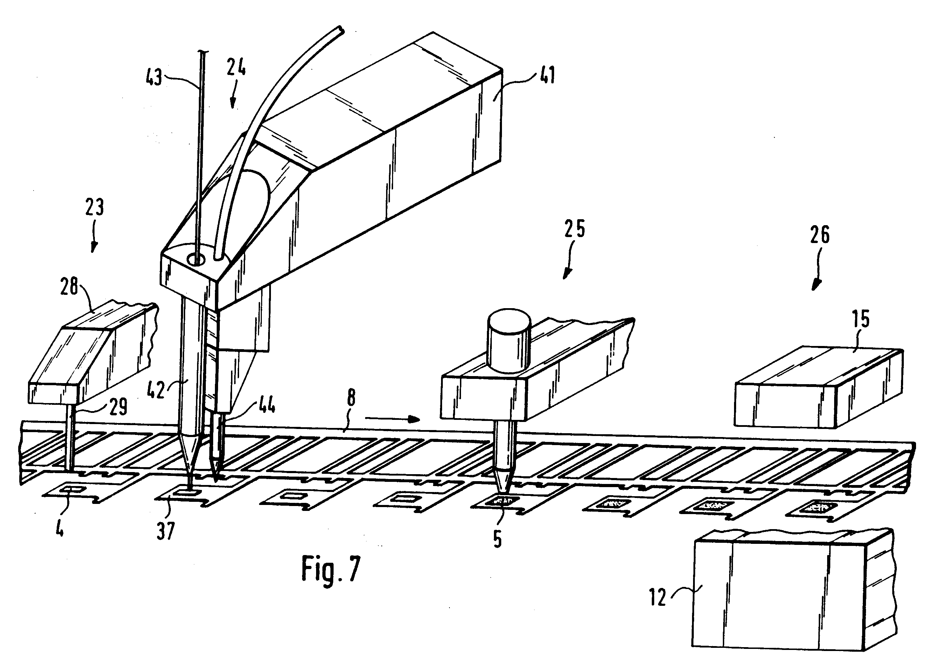

Die Fig. 2 zeigt in vergrößerter Darstellung auch den Innenaufbau des in Fig. 1 dargestellten Ausführungsbeispiels der Erfindung. Diese Darstellung ist dadurch erreicht, daß kein Gießharz in den Becher 1 eingefüllt und die Kunstharzabdeckung 5 (vgl. Fig. 7) weggelassen ist, so daß die Zuleitungen 30, 31, 32 und der Halbleiterkörper 4 sowie weitere Einzelheiten zeichnerisch darstellbar sind.

Jede der beiden äußeren Zuleitungen 31, 32 greift mit der daran angebrachten Nase 7 und mit leichtem Preßsitz in die entsprechende Nut 61, 62 ein. Der Preßsitz ergibt sich durch entsprechende Bemessung des Nasenaußenmaßes bezüglich des Innenmaßes der Seitenwandnuten. Durch den leichten Preßsitz soll verhindert werden, daß die Becher, solange das Gießharz noch nicht ausgehärtet ist, vom Montageband abfallen können.

Die Nut 61 beginnt an der Öffnung des Hohlraumes des Bechers 1a und verläuft senkrecht zu dessen Boden 1 auf ihn zu. In ihm verläuft die Nut 60 senkrecht auf die gegenüberliegende Seitenwand zu, in der die Nut 62 parallel zur Nut 61 bis zur Öffnung verläuft. Es ist nicht erforderlich, daß die Nuten 61, 60, 62 eine durchgehend umlaufende Nut bilden, jedoch sollen deren Teilstücke in einer Ebene liegen.

Anstatt die beiden äußeren Zuleitungen 31, 32 mit der jeweiligen Nase 7 zu versehen, liegt es im Rahmen der Erfindung, auf andere Art und Weise die äußeren Zuleitungen 31, 32 so auszubilden, daß sie in die Nuten 61, 62 eingreifen. Zum Beispiel kann dies dadurch geschehen, daß die Zuleitungen 31, 32 im Gehäusebereich breiter ausgebildet sind als außerhalb des Gehäuses, wobei diese Verbreiterung nicht auf der gesamten Länge der inneren Zuleitungsenden vorhanden zu sein braucht.

Auf dem inneren Ende der mittleren Zuleitung 30, das eine entsprechend große Fläche hat, sitzt der Halbleiterkörper 4, während seine an der Oberfläche liegenden weiteren Zonen über jeweils einen Bonddraht mit den äußeren Zuleitungen 31, 32 kontaktiert sind. Halbleiterkörper 4, Bonddrähte und entsprechende Bezirke der Zuleitungen sind mit der Kunstharzabdeckung 5 (vgl. Fig.7) versehen. Diese kann beispielsweise dadurch erzeugt werden, daß eine entsprechende Menge eines Kunstharzpulvers aufgebracht wird, das anschließend durch Erwärmen aushärtet, oder daß ein entsprechender Tropfen fließfähigen Kunstharzes aufgebracht und anschließend ebenfalls gehärtet wird.

In Ausgestaltung der Erfindung ist bei einem TO-92-Gehäuse der Hohlraum des Bechers 1 senkrecht zur Ebene der eingesteckten Zuleitungen 3 nur so weit, daß der Halbleiterkörper 4 mit der Kunstharzabdeckung gerade einsteckbar ist. Dann liegen die halbleiterkörperabgewandten Flächen der Zuleitungen auf der mit der äußeren Sektorfläche 1b des TO-92-Gehäuses parallelen Innenfläche 1c gerade auf und die Nuten 61, 62 verlaufen am Übergang dieser Innenfläche zu den Seitenwänden des Hohlraums.

Fig. 3 zeigt den zentralen Vertikalschnitt durch die Anordnung nach Fig. 2, so daß darin auch ersichtlich wird, wie in die Bodennut 60 der Stirnteil 38 (vgl. Fig. 4) eines der inneren Zuleitungsenden eingreift.

Die Fig. 4 zeigt als Ausführungsbeispiel den Ausschnitt aus dem Montageband 8 für die Zuleitungen 3, wie es bei der Erfindung verwendet wird. Jeweils drei Zuleitungen sind zu einem Zuleitungstripel dadurch zusammengefaßt, daß mittels des schmalen Quersteges und des breiten Quersteges, der Löcher im Abstand des Rastermaßes des Montagebands 8 enthält, mechanisch versteift und fest miteinander verbunden sind. Im Bereich der inneren Zuleitungsenden 39 sind die Nasen 7, die flächenartige Erweiterung 37 der einen Zuleitung - in Fig. 4 ist dies die äußere Zuleitung 31, während dies in Fig. 2 aus zeichnerischen Gründen die mittlere Zuleitung 30 ist - und der Stirnteil 38 gezeigt.

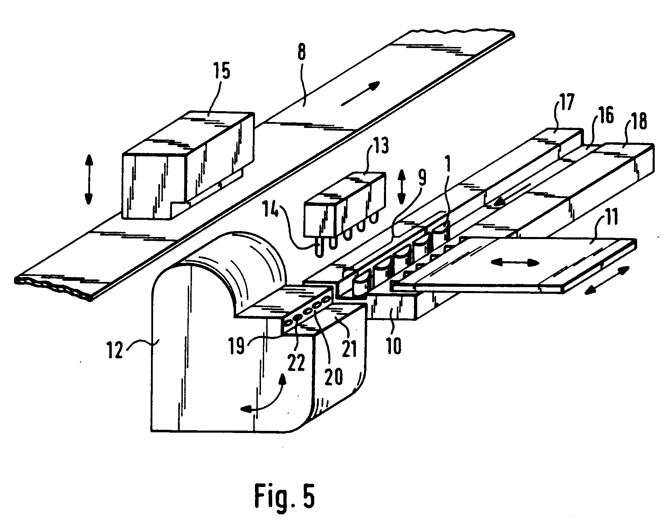

Die Fig. 5 zeigt perspektivisch und schematisiert ein Ausführungsbeispiel einer erfindungsgemäßen Vorrichtung zum Einbringen von Halbleiterkörpern und ihren Zuleitungen in die geschilderten becherförmigen Gehäuse. Diese Vorrichtung enthält die Zuführschiene 10, in die die Becher mit nach oben gerichteten Öffnungen einlaufen. Vorher können sie in einer der üblichen Ausrichtvorrichtungen, wie z.B. einem entsprechend konstruierten Wendelförderer, ausgerichtet werden. Im Falle der erwähnten TO-92-Gehäuse werden sie so ausgerichtet, daß sie mit ihrer Seitenfläche an der einen Seitenwand der Schiene 10 entlanggleiten.

Der in Längsrichtung der Zuführschiene 10 und senkrecht dazu beweglich angeordnete Zentrierschieber 11 kann eine vorgegebene Teilmenge 9 der Becher 1 erfassen und ist am Austrittsende der Zuführschiene 10 angeordnet - in Fig. 5 bilden fünf Becher die Teilmenge 9.

Anschließend an die Austrittsöffnung der Zuführschiene 10 ist der Schwenkgreifer 12 angeordnet, auf den die Teilmenge 9 vom Zentrierschieber 11 geschoben wird. Besonders vorteilhaft ist es, wenn jeder Becher 1 auf dem Schwenkgreifer 12 über eine der Ansaugöffnungen 22 und den darin herrschenden momentanen Unterdruck festgehalten werden kann. Der Schwenkgreifer 12 ist durch axiales Verdrehen um seine Längsachse z.B. um 90^{o} schwenkbar, so daß die auf ihm gehaltenen Becher 1 der Teilmenge 9 mit waagrecht nach oben liegenden Öffnungen so verdreht werden können, daß die Öffnungsfläche etwa senkrecht zu liegen kommt.

Oberhalb der Öffnungen der Becher 1 ist der Gießharzdosierer 13 angeordnet, der soviele Auslässe 14, vorzugsweise in Form von Auslaufstutzen, enthält, wie die Teilmenge 9 Becher hat, und der gerade soviel Gießharz in den Hohlraum der Becher 1 füllt, daß nach dem Einstecken des Halbleiterkörpers etc. der Hohlraum gefüllt ist. Die Auslässe 14 sind dabei im Rastermaß der nebeneinander liegenden Becher angeordnet. Der Gießharzdosierer 13 kann sowohl oberhalb der Becher der Teilmenge 9, die vom Zentrierschieber 11 zu erfassen sind, als auch oberhalb der vom Schwenkgreifer 12 bereits festgehaltenen Teilmenge angeordnet sein, wobei der letzteren Möglichkeit im allgemeinen der Vorzug zu geben ist, da dann die Becher vor der Füllung mit Gießharz besonders gut fixiert sind.

Das mit den Halbleiterkörpern, seinen Bonddrähten und der Kunstharzabdeckung versehene Montageband 8 läuft oberhalb des Schwenkgreifers 12 vorbei und wird vom Niederhalter 15 temporär fixiert, so daß auf die so ebenfalls fixierten Halbleiterkörper etc. die vom Schwenkkörper 12 gehaltene Becherteilmenge während dessen Verdrehens aufgeschoben werden kann und somit jeweils ein Becher auf einen Halbleiterkörper etc. paßt.

In weiterer Ausgestaltung der Vorrichtung nach Fig. 5 hat die Zuführschiene 10 ein U-förmiges Profil mit dem Boden 16, dem längeren Schenkel 17 und dem kürzeren Schenkel 18, wobei der Zentrierschieber 11 am kürzeren Schenkel 18 angeordnet ist, so daß z.B. die TO-92-Becher am längeren Schenkel 17 mit ihrer Seitenfläche anliegen und über den kürzeren Schenkel 18 hervorstehen, wodurch sie vom Zentrierschieber 11 erfaßt werden können.

Ferner kann in weiterer Ausgestaltung der Vorrichtung nach Fig. 5 der Schwenkgreifer 12 die rechtwinklige Aussparung 19 aufweisen, deren senkrechte Fläche 20 mit der Innenwand des längeren Schenkels 17 der Zuführschiene 10 und deren waagrechte Fläche 21 mit dem Boden 16 fluchtet. In der senkrechten Fläche 20 sind vorzugsweise die bereits erwähnten Ansaugöffnungen 22 angeordnet.

Die Fig. 6 zeigt das Schema eines erfindungsgemäßen Montageplatzes für eine Vielzahl von Halbleiterbauelementen nach der Erfindung. An seiner einen Seite ist das unbestückte Montageband 8, zur Montagebandrolle 81 aufgewickelt, angeordnet. Von dort durchläuft es nacheinander in durch den Pfeil angegebener Transportrichtung die Halbleiterkörper-Aufbringstation 23, die Bondstation 24, die Abdeckstation 25, die Becher-Aufbringstation 26 sowie die Aushärtestation 27, falls das Aushärten nicht an der bestückten Montagebandrolle vorgenommen wird. Nach Verlassen der Aushärtestation 27 wird das nunmehr mit den Halbleiterbauelementen bestückte Montageband 88 zur bestückten Montagebandrolle 82 aufgewickelt.

In Fig. 7 ist die Aneinanderreihung der Stationen 23.. .26 nach Fig. 6 gezeigt. Unter den einzelnen Stationen läuft das Montageband 8 entlang, bei dem aus zeichnerischen Vereinfachungsgründen die Löcher im breiten Quersteg weggelassen sind. Die HalbleiterkörperAufbringstation 23 enthält den Aufnehmer 28 sowie ggf. einen Leitkleber-Dosierer, der vor dem Aufbringen des Halbleiterkörpers 4 auf das Band an der Aufbringstelle ein Tröpfchen Leitkleber plaziert. Der Halbleiterkörper 4 wird durch den drehbar gelagerten Aufnehmer 28 von der eingangs erwähnten Halbleiterplatte über die Kanüle 29 abgenommen, die ihn ansaugt und beim Aufsetzen auf das Montageband 8 wieder freigibt.

Die Bondstation 24 enthält die Schwenkhalterung 41, an der die weitere Kanüle 42 angebracht ist, durch die der von einer nicht gezeigten Rolle ablaufende Bonddraht geführt ist und an deren Spitze er austritt, um durch Absenken der Kanüle 42 auf die Metallschicht der entsprechenden Zone des Halbleiterkörpers 4 aufgedrückt zu werden. Parallel zur Kanüle 42 kann die zusätzliche Kanüle 44 angebracht sein, durch die ein Reduktionsmittel, z.B. Wasserstoff, zur Reduzierung der Oberfläche des flächenförmigen Zuleitungsendes 37 zugeführt werden kann, wenn dieses z.B., wie allgemein üblich, aus Kupfer besteht.

In der Abdeckstation 25 wird auf den auf dem Zuleitungsende 37 befestigten Halbleiterkörper 4 und seine Bonddrähte die erwähnte Menge an Abdeckmittel - als Pulver oder in Tropfenform - aufgebracht. Schließlich gelangt das Montageband 8, das mittels der in Fig. 4 gezeigten Löcher schrittweise von links nach rechts in Pfeilrichtung bewegt wird, zur Becher-Aufbringstation 26, von der in Fig. 5 ein Ausführungsbeispiel gezeigt ist und die in Fig. 7 durch die Teile 12, 15 aus Zeichnungsvereinfachungsgründen nur schematisch angedeutet ist. Das Montageband kann dann noch zur Aushärtestation 27 weiterlaufen, die im einfachsten Fall aus einer ober- oder unterhalb des Montagebands angebrachten Wärmequelle oder UV-Lichtquelle besteht.

Abschließend wird noch das zur Herstellung der Vielzahl von Halbleiterbauelementen auszuführende Verfahren erläutert. Die Halbleiterkörper 4 werden auf den flächenförmigen Zuleitungsenden 37 befestigt und deren Zonen mit den anderen zugehörigen Zuleitungsenden 39 kontaktiert. Anschließend wird jeder Halbleiterkörper 4 mit der Kunstharzabdeckung 5 versehen. Dann wird die Teilmenge 9 der Vielzahl an Bechern 1 gleichzeitig mit dem Gießharz 2 gefüllt und anschließend die zugehörigen Halbleiterkörper 4 mit ihren Zuleitungsenden 39 gleichzeitig in die Becher eingesteckt. Darauf wird das Montageband 8 zur Aushärtung des Gießharzes 2 erwärmt, wobei ggf. die Kunstharzabdeckung 5 weiter aushärten kann.

Das Aufbringen der Kunstharzabdeckung 5 geschieht dabei, wie bereits erläutert, durch Aufbringen einer bemessenen Menge Kunstharzpulver oder eines entsprechenden Kunstharztropfens und nachfolgendes Erwärmen.

Es liegt im Rahmen des durchschnittlichen fachmännischen Könnens, die Erfindung so abzuwandeln, daß sie auch bei anderen Kunststoff-Gehäusetypen als dem anhand des Ausführungsbeispiels beschriebenen realisiert werden kann. Es ist dem Fachmann klar, daß die konstruktive Ausbildung der erfindungsgemäßen Vorrichtung zum Aufbringen der Becher auf die Halbleiterkörper etc. von der Gehäuseform abhängig ist und daß bei anderen Gehäusetypen diese Vorrichtung konstruktiv geringfügig abgewandelt werden muß.

## Patentansprüche

1. Halbleiterbauelement
- mit einem aus Kunststoff vorgefertigten Becher (1), der mit Gießharz (2) gefüllt ist,
- mit einem auf dem in den Becher (1) eingesteckten inneren Ende einer von mehreren Zuleitungen (3) sitzenden Halbleiterkörper (4), von dem jeweils eine Zone mit dem inneren Ende einer der anderen Zuleitungen (3) kontaktiert ist und der mit einer Kunstharzabdeckung (5) versehen ist,
- mit jeweils einer im Hohlraum des Bechers (1) von dessen Öffnung in der einen Seitenwand senkrecht auf den Boden (1a) zu verlaufend, in diesem und in der anderen Seitenwand parallel zu der der einen Seitenwand verlaufend angebrachten Nut (61, 60, 62),
- mit derart in den Becher (1) eingesteckten inneren Enden (39) der Zuleitungen (3), daß je eine außen liegende Zuleitung (31, 32) in die entsprechende Seitenwandnut (61, 62) mit leichtem Preßsitz und Stirnteile (38) mindestens eines inneren Zuleitungsendes (39) in die Bodennut (60) mindestens teilweise eingreifen.

2. Halbleiterbauelement nach Anspruch 1, bei dem an den zu den Seitenwänden gerichteten Kanten der äußeren Zuleitungen (31, 32) jeweils mindestens eine Nase (7) angebracht ist.

3. Halbleiterbauelement nach Anspruch 1 oder 2, bei dem der Hohlraum des Bechers (1) senkrecht zur Ebene der eingesteckten Zuleitungen (3) nur so weit ist, daß Halbleiterkörper (4), Zuleitungen (3) und Kunstharzabdeckung (5) gerade einsteckbar sind.

4. Verfahren zum Herstellen einer Vielzahl von Halbleiterbauelementen nach einem der Ansprüche 1 bis 3, bei dem
- deren Zuleitungen (3) zu einem Montageband (8) vereinigt sind, das erst nach Fertigstellung der Umhüllung der Halbleiterbauelemente elektrisch und mechanisch in die zu den einzelnen Halbleiterbauelementen gehörenden Zuleitungen (3) aufgetrennt wird,
- je ein Halbleiterkörper (4) auf einem flächenförmigen Zuleitungsende (37) befestigt und dessen Zonen mit den anderen zugehörigen Zuleitungsenden (39) kontaktiert wird,
- anschließend jeder Halbleiterkörper (4) mit der Kunstharzabdeckung (5) versehen wird,
- eine Vielzahl an Bechern (1)vorgesehen wird,
- in eine Teilmenge (9) der Vielzahl an Bechern (1) gleichzeitig die erforderliche Menge an Gießharz (2) eingefüllt und anschließend die zugehörigen Halbleiterkörper (4) mit ihren Zuleitungsenden (39) gleichzeitig eingesteckt werden und
- anschließend das Montageband (8) mindestens zur Aushärtung des Gießharzes (2) erwärmt wird.

5. Verfahren nach Anspruch 4, dadurch gekennzeichnet, daß die Kunstharzabdeckung (5) durch Aufbringen eines Kunstharztropfens oder von Kunstharzpulver und nachfolgendes Erwärmen erzeugt wird.

6. Vorrichtung zum Einbringen von Halbleiterkörpern (4) und seinen Zuleitungen in Becher (1) nach Anspruch 4 oder 5,
- mit einer Zuführschiene (10), in die die Becher (1) mit nach oben gerichteten Öffnungen einlaufen und an deren Austrittsende ein die Teilmenge (9) seitlich erfassender Zentrierschieber (11) in Längsrichtung der Zuführschiene (10) und senkrecht dazu beweglich angeordnet ist,
- mit einem an die Austrittsöffnung der Zuführschiene (10) schließenden Schwenkgreifer (12), auf den die Teilmenge (9) vom Zentrierschieber (11) geschoben wird,
- mit einem Gießharzdosierer (13), der oberhalb der Öffnungen der Becher (1) vorzugsweise vertikal beweglich angeordnet ist und der soviele Auslässe (14), wie die Teilmenge (9) Becher (1) hat, aufweist, welche Auslässe (14) im Rastermaß der nebeneinander liegenden Becher angeordnet sind, und
- mit einem einen mindestens einige Halbleiterkörper (4) enthaltenden Abschnitt des Montagebandes (8) temporär fixierenden Niederhalter (15), der oberhalb des Schwenkgreifers (12) so angeordnet ist, daß die davon gehaltene Becherteilmenge durch Schwenken auf die fixierten Halbleiterkörper (4) paßt.

7. Vorrichtung nach Anspruch 6, dadurch gekennzeichnet, daß die Zuführschiene (10) ein U-förmiges Profil mit einem Boden (16), einem längeren Schenkel (17) und einem kürzeren Schenkel (18) aufweist und daß der Zentrierschieber (11) am kürzeren Schenkel (18) angeordnet ist.

8. Vorrichtung nach Anspruch 7, dadurch gekennzeichnet, daß der Schwenkgreifer (12) eine rechtwinklige Aussparung (19) aufweist, deren senkrechte Fläche (20) mit der Innenwand des längeren Schenkels (17) und deren waagrechte Fläche (21) mit dem Boden (16) der Zuführschiene (10) fluchtet.

9. Vorrichtung nach einem der Ansprüche 6 bis 8, dadurch gekennzeichnet, daß der Gießharzdosierer (13) mit Auslaufstutzen versehen ist.

10. Vorrichtung nach einem der Ansprüche 6 bis 9, dadurch gekennzeichnet, daß der Schwenkgreifer (12) in der senkrechten Fläche (20) soviele Ansaugöffnungen (22) aufweist, wie die Teilmenge (9) Becher (1) hat .

11. Montageplatz für eine Vielzahl von Halbleiterbauelementen nach einem der Ansprüche 1 bis 3,
- an dessen einer Seite das unbestückte Montageband (8) zu einer Montagebandrolle (81) aufgewickelt angeordnet ist, von der es folgende in Transportrichtung nacheinander angeordnete Stationen durchläuft:
- eine Halbleiterkörper-Aufbringstation (23),
- eine Bondstation (24),
- eine Abdeckstation (25),
- eine Becher-Aufbringstation (26) und
- an welchen Montageplatzes anderer Seite das mit dem Halbleiterbauelementen bestückte und zu einer bestückten Montagebandrolle (82) sich aufwickelnde Montageband (88) angeordnet ist.

12. Montageplatz nach Anspruch 11 mit einer Aushärtestation (27) hinter der Becher-Aufbringstation (26).

## Claims

1. Semiconductor device comprising
- a prefabricated plastic can (1) filled with cast resin (2),
- a die (4) which is seated on the inner end of one of several leads (3), said inner end being inserted in the can (1), and which has areas each connected with the inner end of one of the other leads (3), and is provided with a synthetic-resin cover (5),
- grooves (61, 60, 62) in the hollow space of the can (1) which extend, respectively, from the opening of the can along one sidewall toward the bottom (1a) in a direction perpendicular to the bottom (1a), along the latter, and along the other sidewall parallel to said one sidewall, and
- inner ends (39) of the leads (3) so inserted into the cans (1) that each of the outer leads (31, 32) engages the corresponding sidewall groove (61, 62) with a slight press fit, and that end portions (38) of at least one inner lead end (39) engage the bottom groove (60) at least in part.

2. A semiconductor device as claimed in claim 1 wherein at least one lug (7) is provided on those edges of each of the outer leads (31, 32) which are directed toward the sidewalls.

3. A semiconductor device as claimed in claim 1 or 2 wherein in the plane perpendicular to the plane of the inserted leads (3), the hollow space of the can (1) is only so wide that die (4), leads (3), and synthetic-resin cover (5) are just insertable.

4. Method of manufacturing a plurality of semiconductor devices as claimed in any one of claims 1 to 3, wherein
- the leads (3) of the semiconductor devices are combined to form a lead frame (8) which is electrically and mechanically separated into the leads (3) associated with the individual semiconductor devices only after completion of the encapsulations of the semiconductor devices,
- a die (4) is mounted on an flat end (37) of one of the leads associated therewith, and its contact areas are connected with the ends (39) of the other associated leads,
- each die (4) is then provided with the synthetic-resin cover (5),
- a plurality of cans (1) are provided,
- a subset (9) of the plurality of cans (1) is simultaneously filled with the necessary quantity of cast resin (2), and the associated dice (4), together with their inner lead ends (39), are then inserted simultaneously, and
- the lead frame (8) is then heated to cure at least the cast resin (2).

5. A method as claimed in claim 4, characterized in that the synthetic-resin cover (5) is formed by applying a synthetic-resin drop or synthetic-resin powder and then heating it.

6. Apparatus for inserting dice (4) and their leads into cans (1) as claimed in claim 4 or 5, comprising
- a feed rail (10) which the cans (1) enter with their openings directed upwards and at whose exit end is disposed a centering slide (11) which is movable in the longitudinal direction of and perpendicular to the feed rail (10) and grasps the subset (9) laterally,
- a swivelling gripper (12) which follows the exit opening of the feed rail (10) and onto which the subset (9) is pushed by the centering slide (11),
- a preferably vertically movable cast-resin-metering device (13) disposed above the openings of the cans (1) and having a number of outlets (14) equal to the number of cans (1) of the subset (9), the spacing of said outlets (14) being equal to that of the cans arranged side by side, and
- a hold-down device (15) which temporarily fixes a section of the lead frame (8) containing at least some dice (4) and is so mounted above the swivelling gripper (12) that the subset of cans held by the latter fits on the fixed dice (4) after a swivelling motion.

7. An apparatus as claimed in claim 6, characterized in that the feed rail (10) has a U-shaped section with a bottom (16), a longer leg (17), and a shorter leg (18), and that the centering slide (11) is disposed at the shorter leg (18).

8. An apparatus as claimed in claim 7, characterized in that the swivelling gripper (12) has a rectangular recess (19) whose vertical surface (20) is flush with the inside wall of the longer leg (17), and whose horizontal surface (21) is flush with the bottom (16) of the feed rail (10).

9. An apparatus as claimed in any one of claims 6 to 8, characterized in that the cast-resin-metering device (13) is provided with an outlet tubule.

10. An apparatus as claimed in any one of claims 6 to 9, characterized in that the swivelling gripper (12) has a number of suction openings (12) in the vertical surface (20) which is equal to the number of cans (1) of the subset (9).

11. Assembly facility for a plurality of semiconductor devices as claimed in any one of claims 1 to 3,
- on one side of which an unequipped lead frame (8) is wound on a reel (81) from which it passes through the following stations arranged one behind the other in the direction of transport:
-- a die -mounting station (23),
-- a bonding station (24),
-- a covering station (25),
-- a can placement station (26), and
- on the other side of which assembly facility the lead frame (88) equipped with the semiconductor devices is wound on a reel (82).

12. An assembly facility as claimed in claim 11 and comprising a curing station (27) behind the can placement station (26).

## Revendications

1. Composant à semiconducteurs comportant
- un pot (1) préfabriqué en une matière plastique et rempli par une résine de coulée (2),
- un corps semiconducteur (4), qui prend appui sur l'extrémité intérieure, enfichée dans le pot (1), d'un parmi plusieurs conducteurs d'alimentation (3) et dont respectivement une zone est en contact avec l'extrémité intérieure de l'un des autres conducteurs d'alimentation (3) et qui porte un revêtement de résine synthétique (5),
- une rainure respective (61, 60, 62) ménagée dans le fond (1a), de manière à s'étendre dans la cavité du pot (1) depuis l'ouverture de ce dernier, dans une première paroi latérale perpendiculairement audit fond, et de manière à s'étendre dans l'autre paroi latérale parallèlement à la première paroi latérale,
- des extrémités intérieures (39) des conducteurs d'alimentation (3), enfichées dans le pot de telle sorte que respectivement un conducteur d'alimentation extérieur (31,32) s'engage au moins partiellement selon un ajustement faiblement serré dans la rainure correspondante (61,62) et que des parois frontales (38) d'au moins une extrémité intérieure (39) du conducteur d'alimentation s'engagent au moins partiellement dans la rainure (60) du fond.

2. Composant à semiconducteurs selon la revendication 1, dans lequel respectivement au moins un bec (7) est disposé sur les bords, dirigés vers les parois latérales, des conducteurs d'alimentation (31,32).

3. Composant à semiconducteurs selon la revendication 1 ou 2, dans lequel la cavité du pot (1) est juste suffisamment large, perpendiculairement au plan des conducteurs d'alimentation enfichés (3), pour permettre précisément l'enfichage du corps semiconducteur (4), des conducteurs d'alimentation (3) et du revêtement (5) formé d'une résine synthétique.

4. Procédé pour fabriquer une multiplicité de composants à semiconducteurs suivant l'une des revendications 1 à 3, selon lequel
- on réunit les conducteurs d'alimentation (3) de ces composants à une bande de montage (8), qu'on subdivise du point de vue électrique et mécanique, uniquement après la fabrication de l'enveloppe des composants à semiconducteurs, en les composants individuels (3) associés aux différents composants à semiconducteurs,
- on fixe respectivement un corps semiconducteur (4) sur une extrémité de surface étendue (37) d'un conducteur de raccordement et on établit un contact entre les zones de cette extrémité et les autres extrémités associées (39) des conducteurs d'alimentation,
- on équipe ensuite chaque corps semiconducteur (4) avec un revêtement (5) en résine synthétique,
- on prévoit une multiplicité de pots (1),
- on introduit simultanément la quantité requise de résine de coulée (2) dans une quantité partielle (9) de l'ensemble de pots (1) et on enfiche ensuite simultanément les corps semiconducteurs associés (4) avec les extrémités (39) de leurs conducteurs d'alimentation, et
- ensuite, on chauffe la bande de montage (8) au moins pour faire durcir la résine de coulée (2).

5. Procédé selon la revendication 4, caractérisé en ce qu'on forme le revêtement (5) en résine synthétique par dépôt d'une goutte de résine synthétique ou d'une poudre de résine synthétique et chauffage ultérieur.

6. Dispositif pour introduire des corps semiconducteurs (4) et leurs conducteurs d'alimentation dans des pots (1) selon la revendication 4 ou 5, comportant
- un rail d'amenée (10), dans lequel les pots (1) pénètrent avec leurs ouvertures dirigées vers le haut et sur l'extrémité de sortie duquel un poussoir de centrage (11), qui saisit latéralement la quantité partielle de pots (9), est disposé de manière à être déplaçable dans la direction longitudinale du rail d'amenée (10) et perpendiculairement à cette direction,
- un élément de préhension pivotant (12), qui ferme l'ouverture de sortie du rail d'amenée (9) et sur lequel la quantité partielle (9) de pots est repoussée par le poussoir de centrage (11),
- un dispositif (13) de dosage de la résine de coulée, qui est disposé au-dessus des ouvertures des pots (1) en étant de préférence mobile verticalement et qui possède un nombre de sorties (14) égal au nombre des pots (1) de la quantité partielle (9) de pots, lesquelles sorties (14) sont disposées avec le pas de répartition des pots disposés côte-à-côte, et
- un serre-flan (15), qui fixe temporairement une section de la bande de montage (8), qui contient au moins quelques corps semiconducteurs (4) et qui est disposée au-dessus de l'organe de préhension pivotant (12) de sorte que la quantité partielle de pots, maintenus par cet organe de préhension, s'adapte par pivotement sur les corps semiconducteurs (4) fixés.

7. Dispositif selon la revendication 6, caractérisé en ce que le rail d'amenée possède un profil en forme de U comportant une base (16), une branche plus longue (17) et une branche plus courte (18) et que le poussoir de centrage (11) est disposé sur la branche plus courte (18).

8. Dispositif selon la revendication 7, caractérisé en ce que l'organe de préhension pivotant (12) possède un évidement rectangulaire (19), dont la surface verticale (20) est alignée avec la paroi intérieure de la branche la plus longue (17) et dont la surface horizontale (21) est alignée avec la base (16) du rail d'amenée (10).

9. Dispositif selon l'une des revendications 6 à 8, caractérisé en ce que le dispositif (13) de dosage de la résine de coulée est équipé de tubulures de sortie.

10. Dispositif selon l'une des revendications 6 à 9, caractérisé en ce que l'organe de préhension pivotant (12) possède, dans la surface verticale (20), autant d'ouvertures d'aspiration (22) qu'il y a de pots dans la quantité partielle (9) de pots.

11. Poste de montage pour une multiplicité de composants à semiconducteurs selon l'une des revendications 1 à 3,
- d'un côté duquel la bande de montage non équipée (8) est disposée à l'état enroulé sous la forme d'un rouleau (81), à partir duquel la bande de montage traverse des postes successifs disposés les uns derrière les autres dans la direction de transport :
- un poste (23) de dépôt des corps semiconducteurs,
- un poste de fixation (24),
- un poste de revêtement (25),
- un poste (26) de dépôt des pots, et
- sur l'autre côté du poste de montage est installée la bande de montage (88) qui est équipée du composant à semiconducteurs et est enroulée pour former un rouleau équipé (82) de la bande de montage.

12. Poste de montage selon la revendication 11, comportant un poste de durcissement (27) situé en aval du poste (26) de dépôt des pots.
